(19) Europäisches Patentamt
European Patent Office
Office européen des brevets

(11) **EP 2 238 687 B1**

(12) **FASCICULE DE BREVET EUROPEEN**

(45) Date de publication et mention
de la délivrance du brevet:
**08.08.2012 Bulletin 2012/32**

(21) Numéro de dépôt: **09708573.2**

(22) Date de dépôt: **28.01.2009**

(51) Int Cl.:
***H03K 19/003*** *(2006.01)*

(86) Numéro de dépôt international:
**PCT/EP2009/050945**

(87) Numéro de publication internationale:
**WO 2009/098153 (13.08.2009 Gazette 2009/33)**

(54) **CIRCUIT INTEGRE A GRAND NOMBRE DE CIRCUITS ELEMENTAIRES IDENTIQUES ALIMENTES EN PARALLELE**

INTEGRIERTER SCHALTKREIS MIT VIELEN IDENTISCHEN PARALLELGESCHALTETEN ELEMENTARSCHALTUNGEN

INTEGRATED CIRCUIT INCLUDING A LARGE NUMBER OF IDENTICAL ELEMENTARY CIRCUITS POWERED IN PARALLEL

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **08.02.2008 FR 0800678**

(43) Date de publication de la demande:
**13.10.2010 Bulletin 2010/41**

(73) Titulaire: **E2V Semiconductors**
**38120 Saint Egrève (FR)**

(72) Inventeurs:
• **NICOLAS, Jean-Alain**
**F-38000 Grenoble (FR)**

• **MORISSON, Richard**
**F-38000 Grenoble (FR)**

(74) Mandataire: **Guérin, Michel**
**Marks & Clerk France**
**Conseils en Propriété Industrielle**
**Immeuble Visium**
**22, Avenue Aristide Briand**
**94117 Arcueil Cedex (FR)**

(56) Documents cités:
**US-A1- 2006 125 672    US-A1- 2007 040 719**
**US-A1- 2007 216 564**

**Description**

L'invention concerne les circuits intégrés comportant un grand nombre de circuits élémentaires identiques qui doivent recevoir en parallèle des tensions de référence identiques d'un circuit élémentaire à l'autre.

Par "grand nombre", on entend un nombre d'au moins égal à vingt et de préférence au moins cinquante. Les tensions identiques sont des tensions de référence qui peuvent être éventuellement mais non obligatoirement des tensions d'alimentation du circuit intégré.

Une application typique envisagée est celle des convertisseurs analogique-numérique de grande résolution, typiquement des convertisseurs de 12 ou 14 bits dont la structure est fortement parallèle pour permettre d'assurer une conversion très rapide. Les convertisseurs de type flash, par exemple, ont une structure fortement parallèle en ce sens que de très nombreux comparateurs de tension individuels effectuent simultanément une opération de comparaison entre une tension d'entrée et diverses tensions de référence. Ces comparateurs peuvent utiliser chacun une ou plusieurs sources de courant et toutes les sources de courant doivent être parfaitement identiques les unes aux autres sous peine de fausser le résultat de la conversion. Dans un exemple de convertisseur de résolution 14 bits, on peut avoir plus de trois cents sources de courant juxtaposées qui doivent délivrer toutes des courants rigoureusement identiques. Pour établir ces courants, chaque source comprend par exemple un transistor qui reçoit deux potentiels de référence ; l'un des potentiels est un potentiel de polarisation de la base, l'autre est un potentiel d'alimentation (par exemple un potentiel de masse) auquel l'émetteur ou la source du transistor est relié, directement ou par l'intermédiaire d'une résistance d'émetteur ou de source. Pour que tous les courants établis par ces sources soient rigoureusement identiques, il faut d'une part que tous les transistors et leurs résistances soient identiques, et il faut aussi qu'ils reçoivent tous le même potentiel de polarisation et le même potentiel d'alimentation.

Dans ces structures à grand nombre de circuits élémentaires identiques devant tous recevoir en parallèle un même potentiel, que ce soit un potentiel d'alimentation haut ou un potentiel d'alimentation bas, ou un potentiel de référence, ou un potentiel à mesurer, on rencontre une difficulté qui est liée au fait que les conducteurs d'amenée de tension n'ont pas une conductivité infinie mais une conductivité limitée par des facteurs technologiques ; or les circuits élémentaires identiques consomment chacun un courant qui circule dans ce conducteur d'amenée de tension ; une chute de tension se produit dans ce conducteur en proportion du courant consommé par les circuits élémentaires, de sorte que les circuits élémentaires reçoivent des tensions différentes selon qu'ils sont placés plus près ou plus loin d'une extrémité amont du conducteur.

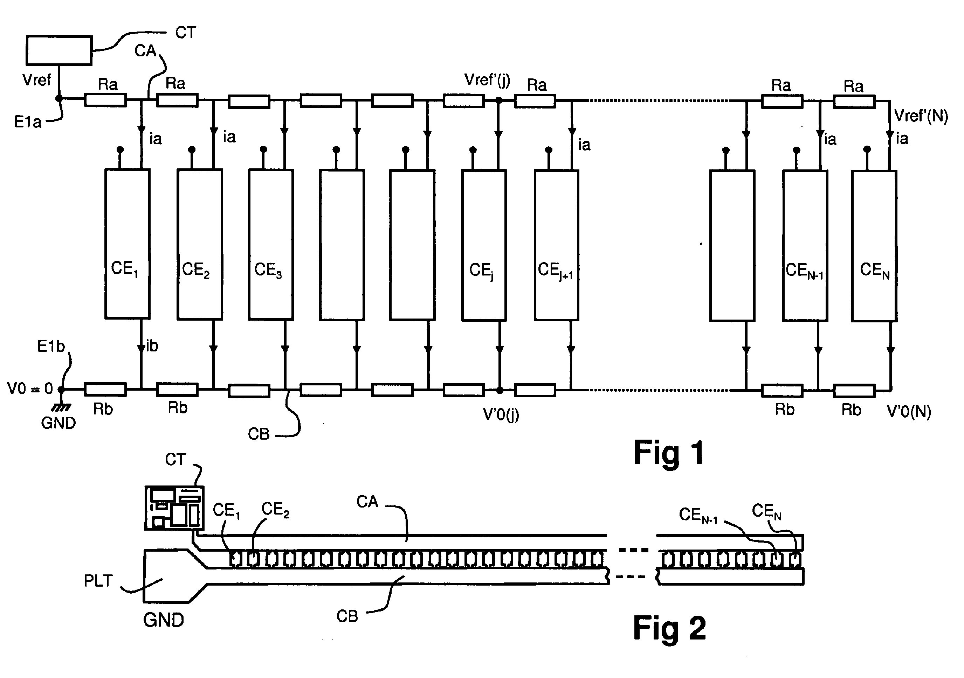

Le phénomène de chute de tension est explicité à la figure 1 dans le cas exemplaire de N circuits élémentaires $CE_1$, $CE_2$, ...$CE_J$, ...$CE_N$ connectés entre un conducteur de polarisation CA convoyant un potentiel de référence Vref et un conducteur de masse CB convoyant un potentiel d'alimentation V0 égal à 0 (potentiel de masse). On suppose que les circuits élémentaires consomment chacun un courant ia en provenance du conducteur de polarisation et qu'ils restituent chacun un courant ib vers le conducteur de masse. Dans l'exemple d'un circuit élémentaire qui est une source de courant formée par un transistor bipolaire, le courant ia est le courant consommé par la base du transistor, et le courant ib est le courant d'émetteur. Le collecteur sert par exemple à tirer un courant ic = ia+ib d'une paire différentielle (non représentée) utilisée dans un comparateur de tensions ou de courants associé à chaque circuit élémentaire. On suppose que le conducteur de masse et le conducteur d'alimentation ont tous les deux une résistivité propre non nulle, telle que la résistance du conducteur entre deux circuits élémentaires $CE_j$ et $CE_{J+1}$ adjacents, de rang j et j+1, espacés d'un pas d ait une valeur Ra pour le premier conducteur CA et une valeur Rb pour le deuxième conducteur CB.

Pour le conducteur CA transportant le potentiel Vref, on considère en outre, pour simplifier les calculs, qu'il y a une résistance Ra entre le circuit qui élabore la tension Vref et le premier circuit élémentaire $CE_1$. Pour le conducteur de masse CB on considère aussi qu'il y a une résistance Rb entre la masse véritable GND et le premier circuit élémentaire $CE_1$.

Dans ces conditions, on peut montrer facilement que le dernier tronçon de résistance Ra du conducteur CA produit une chute de tension Ra.ia, que l'avant dernier produit une chute de tension 2.Ra.ia, etc. On peut alors montrer par le calcul que la tension d'alimentation véritablement appliquée à la tête du circuit élémentaire $CE_j$ de rang j n'est pas Vref mais V'ref(j) = Vref-Ra.ia.j.(2N+1-j)/2, N étant le nombre total de circuits.

De même, une chute de tension existe dans le conducteur CB, de sorte que le pied du circuit élémentaire $CE_j$ de rang j n'est pas relié au potentiel 0 de la masse mais plutôt à un potentiel Rb.ib.j.(2N+1-j)/2.

La différence de potentiel V'ref(j) - V'0(j) appliquée alors entre la tête et le pied d'un circuit élémentaire de rang j est donc

$$\text{V'ref(j) - V'0(j) = Vref-(Ra.ia+Rb.ib).j.(2N+1-j)/2.}$$

L'écart par rapport à Vref est d'autant plus grand que N est plus grand, et cet écart atteint N.(N+1).(Ra.ia+Rb.in)/2 pour le circuit élémentaire de rang j. SI N est supérieur à 100, on voit que l'erreur sur la différence de potentiel appliquée au circuit de rang N est 10 000 fois la chute de tension dans un tronçon élémentaire, parcouru par un courant élémentaire, des conducteurs CA et CB. Si N est égal à 300, c'est presque 100 000 fois cette chute. Même si la chute de tension élémentaire est très faible, l'erreur devient importante lorsque N atteint une ou plusieurs centaines.

Pour rendre la différence de potentiel appliquée aussi proche que possible de Vref, la solution classique est donc de réduire le plus possible la valeur des résistances Ra et Rb. On utilise des conducteurs CA et CB en matériau très conducteur (aluminium ou cuivre de préférence), suffisamment épais (mais avec les contraintes de la technologie utilisée), et suffisamment larges (mais avec un encombrement d'autant plus important).

La figure 2 représente une disposition physique réaliste d'un tel circuit intégré ; le potentiel de référence Vref est produit par un circuit d'élaboration de tension CT qui fait partie du circuit intégré et qui est placé à l'extrémité de la succession de circuits élémentaires. Le potentiel d'alimentation V0 est celui de la masse et peut être fourni par un plot d'alimentation extérieure PLT du circuit intégré.

On pourrait également amener chaque tension individuelle vers les circuits élémentaires à partir d'un conducteur central qui se ramifie en branches successives organisées de telle manière que le trajet depuis le potentiel de référence (Vref ou V0) présente la même résistance vers chacun des circuits. Mais l'encombrement qui résulterait d'une telle structure arborescente est très important s'il y a plusieurs centaines de circuits à alimenter.

L'invention propose une solution pour rendre plus uniforme la différence de potentiel appliquée entre la tête et le pied de chacun des circuits élémentaires juxtaposés, sans augmenter déraisonnablement l'encombrement de la structure.

Selon l'invention on propose un circuit intégré comportant une succession de N circuits élémentaires identiques, juxtaposés dans l'ordre de leur rang j variant de 1 à N, N étant au moins égal à 20, de préférence plus de 50, tous reliés à un premier conducteur qui est connecté, en un point appelé entrée amont du premier conducteur, à un premier potentiel de référence, et qui s'étend à partir de cette entrée amont le long de la succession de circuits élémentaires, et tous reliés par ailleurs à un deuxième conducteur qui est connecté, en un point appelé entrée amont du deuxième conducteur, à un deuxième potentiel de référence, et qui s'étend à partir de cette entrée amont le long de la succession de circuits élémentaires, caractérisé en ce que l'entrée amont du deuxième conducteur est située géographiquement du coté du rang 1 de la succession de circuits juxtaposés, et l'entrée amont du premier conducteur est située géographiquement du côté du rang N de la succession de circuits juxtaposés.

Autrement dit, si on repère les circuits élémentaires par leur rang j de 1 à N le long de la succession, le deuxième conducteur amène le deuxième potentiel de référence en commençant par le circuit élémentaire de rang 1, et en s'étendant progressivement vers les autres circuits dans l'ordre de la succession de rangs 1 à N, alors que le premier conducteur amène le premier potentiel de référence en commençant par le circuit élémentaire de rang N et en s'étendant ensuite progressivement vers les autres dans l'ordre inverse de la succession.

On a constaté en effet qu'en appliquant les deux potentiels de référence, Vref et la masse par exemple, de part et d'autre de la succession et non pas du même côté, on réduisait (sans l'éliminer) l'écart de tension entre le circuit élémentaire qui reçoit la différence de potentiel la plus faible et celui qui reçoit la plus forte. Il y a une compensation partielle d'une chute de tension sur un conducteur par la chute de tension sur l'autre.

De plus, dans le cas où le courant ia prélevé par la tête du circuit élémentaire est différent du courant ib fourni par le pied, on s'arrange de préférence pour avoir une résistance élémentaire entre deux circuits élémentaires adjacents plus élevée pour le conducteur supportant le plus petit courant et plus faible pour le conducteur supportant le plus petit courant. Le choix est fait de préférence de manière à réaliser l'égalité Ra.ia = Rb.ib.

En particulier, dans le cas où le circuit élémentaire est un transistor, le premier conducteur appliquant un potentiel de référence à la base, et le deuxième conducteur servant à dériver le courant d'émetteur vers une masse, on choisit alors une résistance de tronçon entre 20 et 500 fois plus élevée (de préférence entre 100 et 250 fois) pour le conducteur qui est relié aux bases que pour le conducteur qui est relié aux émetteurs. Le rapport choisi est si possible proche du gain en courant bêta (courant collecteur/courant de base) des transistors ; ce gain bêta peut varier, selon la technologie employée, entre quelques dizaines et quelques centaines d'unités, voire même plus ; il est classiquement compris entre 100 et 250.

L'obtention de cette différence de résistances élémentaires se fait en jouant sur les matériaux, leurs épaisseurs, et leurs largeurs.

On remarquera que le choix de résistances élémentaires différentes mais dans le rapport inverse des courants ia et ib permet qu'un seul des conducteurs d'alimentation ait une largeur relativement importante plutôt que les deux ; ceci permet de gagner en encombrement par rapport à une disposition telle que celle de la figure 2.

Selon un perfectionnement, on peut prévoir également que celui des conducteurs qui supporte le courant le plus élevé a une résistance de tronçon élémentaire non constante, qui croît à partir de son extrémité amont (reliée à la masse par exemple). Pour cela on prévoit de préférence que la largeur du conducteur va en diminuant progressivement, continûment ou par paliers, à partir de son entrée amont. La loi de décroissance se rapproche autant que possible de la fonction (N-j+1)/j, en fonction du rang j du tronçon élémentaire de conducteur qui relie les circuits élémentaires de rang j-1 et j.

Dans le cas où le circuit élémentaire est constitué à partir de transistors MOS dont les grilles doivent recevoir la tension de référence, on connecte de préférence à l'extrémité aval du premier conducteur (opposée à l'entrée amont) une source de courant qui crée artificiellement une chute de tension progressive dans le premier conducteur. Le potentiel sur le premier conducteur, qui est Vref à la première extrémité, chute progressivement jusqu'à la deuxième extrémité, en proportion de la résistance et de la valeur du courant de la source de courant rajoutée. La valeur du courant de cette source est choisie de manière à minimiser l'écart qui existe entre les différentes différences de potentiel appliquées aux circuits élémentaires.

Enfin, là encore, on peut prévoir que le conducteur qui recueille les courants de source des différents transistors MOS a une résistance par unité de longueur non constante le long de la succession de circuits élémentaires, et plus précisément une résistance élémentaire de tronçon qui croît (donc une largeur qui décroît) à partir de l'entrée amont au fur et à mesure que le rang j augmente de 1 à N. La loi de décroissance se rapproche de préférence d'une fonction (N-j)/N-j+1) en fonction du rang j du tronçon de conducteur concerné.

Dans toutes ces configurations, le premier conducteur fournissant le courant le plus faible aux circuits élémentaires aura de préférence une largeur plus faible que la largeur moyenne du deuxième conducteur.

D'autres caractéristiques et avantages de l'invention apparaîtront à la lecture de la description détaillée qui suit et qui est faite en référence aux dessins annexés dans lesquels :

- la figure 1, déjà décrite, représente un circuit intégré comportant un grand nombre de circuits élémentaires juxtaposés et devant recevoir tous la tension Vref présente sur un premier conducteur CA ainsi que la tension V0 présente sur un deuxième conducteur CBV relié à la masse GND;
- la figure 2, également déjà décrite, représente une implantation physique possible du circuit de la figure 1 ;
- la figure 3 représente le schéma de principe du circuit intégré selon l'invention ;
- la figure 4 représente un exemple de variation de potentiel le long du conducteur CA et le long du conducteur CB de la figure 1 ;
- la figure 5 représente un exemple de variation de potentiel le long des conducteurs CA et CB du circuit de la figure 2 ;
- la figure 6 représente la variation de la différence de potentiel le long de la succession de circuits élémentaires entre le conducteur CA et le conducteur CB dans le cas de la figure 3 ;
- la figure 7 représente un exemple d'implantation physique réelle du circuit intégré selon invention ;
- la figure 8 représente une autre implantation physique possible ;
- la figure 9 représente une combinaison du principe de l'invention avec un principe d'arborescence des conducteurs ;
- la figure 10 représente une configuration avec un conducteur d'alimentation de largeur variable le long de la succession de circuits ;
- la figure 11 représente un exemple de circuit intégré selon l'invention dans le cas où le circuit élémentaire comporte un transistor MOS et le premier conducteur CA doit fournir une tension de polarisation à la grille de ce transistor MOS.

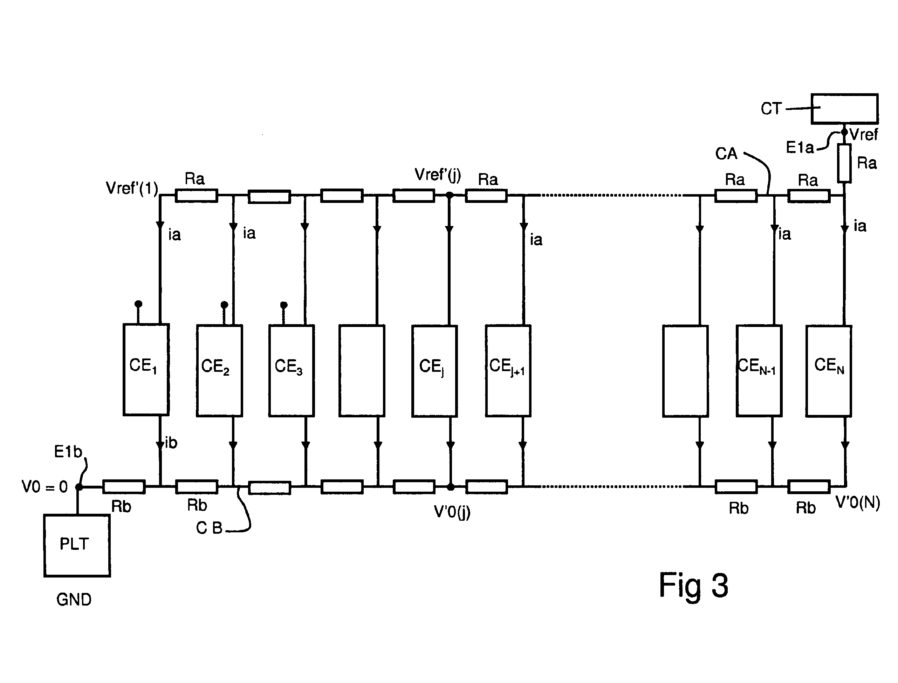

La figure 3 représente le circuit intégré selon l'invention, ou plus exactement la portion de circuit intégré concernée par l'invention, le circuit intégré pouvant évidemment comprendre de nombreux autres éléments.

L'invention sera décrite dans le contexte exposé précédemment, à savoir un convertisseur analogique-numérique ou numérique-analogique de précision capable de délivrer une valeur numérique codée sur 12 ou 14 bits pour chaque valeur de tension analogique appliquée à l'entrée du convertisseur. Le convertisseur utilise des séries nombreuses de sources de courant toutes identiques ; chaque source peut être constituée par un transistor ayant son émetteur (ou sa source) connecté à un conducteur qui est relié à un potentiel de masse V0, avec ou sans résistance d'émetteur, et sa base (ou sa grille) connectée à un conducteur relié à un potentiel de référence Vref. L'invention est applicable à d'autres circuits intégrés dans lesquels se pose le problème d'appliquer une différence de potentiel Vref - V0 à une série de nombreux circuits élémentaires qui doivent recevoir autant que possible tous la même différence de potentiel.

Le circuit de la figure 3 comporte donc un grand nombre N de circuits élémentaires identiques juxtaposés les uns aux autres et désignés par les références $CE_1$, $CE_2$, ... $CE_j$, $CE_{j+1}$, $CE_{N-1}$, $CE_N$.

N est égal à au moins 20 mais on s'intéresse surtout aux circuits dans lesquels N est supérieur à cinquante car ce sont ces circuits qui vont poser le plus de problèmes. Chaque circuit élémentaire a été représenté symboliquement avec trois bornes, deux d'entre elles étant destinées à recevoir deux potentiels de référence qui devraient être rigoureusement identiques pour tous les circuits. La troisième borne sert par exemple à tirer du courant d'une paire différentielle non représentée faisant partie d'un comparateur ou d'un amplificateur différentiel ; en raison de l'identité des différents circuits élémentaires, le courant tiré par cette troisième borne est identique pour tous les circuits élémentaires dès lors que les deux potentiels reçus respectivement sur les deux premières bornes sont identiques. C'est cette identité de courants sur la troisième borne que l'on recherche.

L'un des potentiels de référence, Vref, est appliqué à une première borne par un premier conducteur CA ;

l'autre potentiel de référence, V0, est appliqué à la deuxième borne par un deuxième conducteur CB. La première borne consomme un courant ia, identique pour tous les circuits, par exemple le courant consommé par la base d'un transistor bipolaire. La deuxième borne fournit ou consomme un courant ib, identique pour tous les circuits ; c'est par exemple le courant délivré par l'émetteur ou la source du transistor.

Dans cet exemple, le premier potentiel de référence Vref est établi par un circuit CT qui fait partie du circuit intégré, et le deuxième potentiel de référence V0 est un des potentiels d'alimentation du circuit intégré, ici le potentiel de masse, obtenu par exemple sur un plot conducteur PLT servant à la connexion du circuit intégré avec l'extérieur. On comprendra que l'invention s'applique aussi bien si les deux potentiels de référence ont une autre origine, y compris si l'un des potentiels est un potentiel variable à mesurer.

Le premier conducteur CA est relié, en un point qu'on appellera entrée amont E1a de ce conducteur, au circuit CT, et on peut considérer que le circuit CT fournit un potentiel Vref en ce point ; le conducteur CA s'étend à partir de cette entrée amont E1 a tout le long de la succession de circuits élémentaires.

Le deuxième conducteur CB est relié, en un point qu'on appellera entrée amont E1 b de ce conducteur, au plot PLT, et on peut considérer que le plot PLT fournit un potentiel de masse V0 en ce point ; le conducteur CB s'étend à partir de cette entrée amont E1 b tout le long de la succession de circuits élémentaires.

Selon l'invention, l'entrée amont E1 b du conducteur CB est située à proximité immédiate du premier circuit élémentaire $CE_1$ de rang 1 et le conducteur CB s'étend ensuite le long de la succession de circuits dans l'ordre des rangs j <u>croissants</u> de 1 à N, alors que l'entrée amont E1a du conducteur CA est située à proximité immédiate du dernier circuit élémentaire $CE_N$ de rang N et le conducteur CA s'étend ensuite le long de la succession dans l'ordre des rangs j <u>décroissants</u> de N à 1.

On comprend donc que le plot PLT et le circuit CT sont placés respectivement de part et d'autre de la succession de circuits élémentaires.

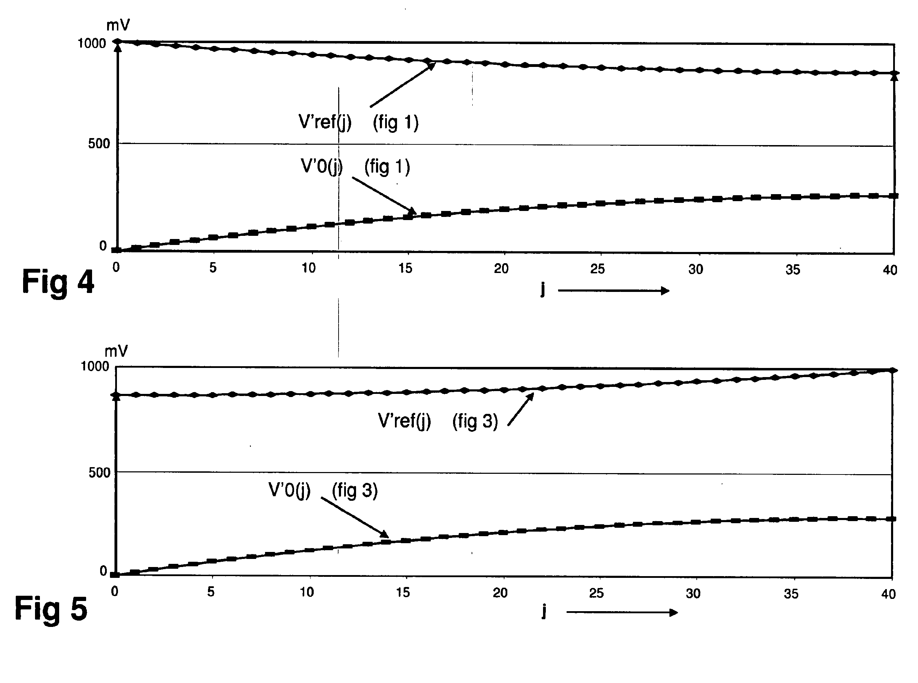

La figure 4 représente des courbes de variation des deux potentiels V'ref(j) et V'0(j) réellement appliqués aux circuits élémentaires de la succession (au lieu de Vref et V0), en fonction de j, lorsque la configuration est celle de la figure 1. Le premier potentiel de référence V'ref(j) décroît régulièrement à partir de Vref au fur et à mesure que le rang j (en abscisse) augmente. Le deuxième potentiel de référence V'0(j) croît régulièrement avec le rang j à partir de V0. Pour simplifier la représentation, on a établi des courbes pour N=40, le principe restant le même lorsque N est plus élevé.

La figure 5 représente les courbes correspondantes V'ref(j) et V'0 lorsque la configuration du circuit intégré est celle de la figure 3. Le premier potentiel V'ref croît progressivement avec le rang j. Le deuxième potentiel de référence V'0 croît régulièrement comme à la figure 4.

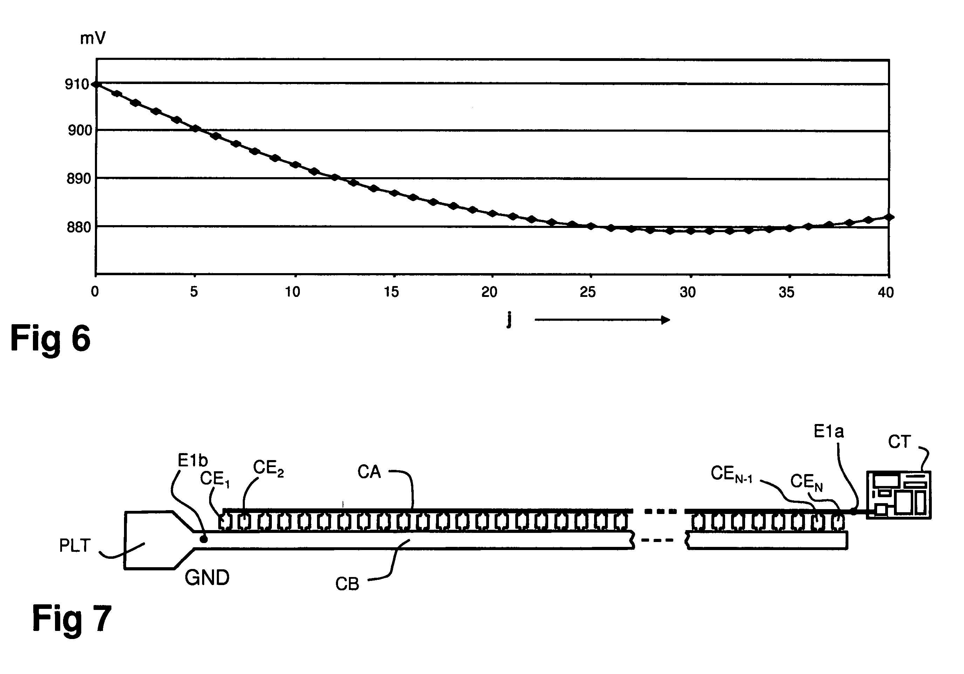

La figure 6 représente la différence de potentiel entre V'ref et V'0. L'échelle est dilatée et décalée en ordonnée pour mieux montrer la forme de la variation avec le rang j : la différence de potentiel varie, mais la limite supérieure est inférieure à ce qu'elle était dans le cas de la configuration de la figure 1, et la limite inférieure n'est pas inférieure à ce qu'elle était dans la configuration de la figure 1. Au total, la différence de potentiel est donc plus constante le long de la succession de circuits élémentaires que ce qu'elle était avec la configuration de la figure 1.

Dans le cas de la figure 1, il faut noter aussi qu'on avait tout intérêt à minimiser la résistance linéique (résistance par unité de longueur) du premier conducteur CA ainsi que celle du deuxième conducteur CB ; en effet la différence de potentiel était d'autant plus constante que la résistance du premier conducteur <u>et</u> la résistance du deuxième conducteur étaient plus faibles.

Au contraire, avec la configuration de la figure 2, on prévoit de préférence que la résistance linéique du premier conducteur est beaucoup plus grande que la résistance linéique du deuxième conducteur, et ceci dans le rapport des courants ib et ia.

Ainsi, par exemple, dans le cas où le circuit élémentaire comprend essentiellement un transistor absorbant un courant de base ia et produisant un courant d'émetteur ib, on choisira de préférence des résistances linéiques dans un rapport Ra/Rb égal au gain en courant bêta du transistor, soit une valeur d'environ 20 à 500 ou de préférence de 100 à 250 (cette valeur dépend de la technologie de réalisation des transistors).

On constate et on vérifie par le calcul qu'en choisissant un rapport Ra/Rb des résistances de tronçons élémentaires sensiblement égal au rapport de courants ib/ia consommés par un circuit élémentaire à partir des conducteurs CB et CA, on minimise l'écart des différences de potentiel au long de la succession de N circuits élémentaires.

On peut choisir de réaliser la bande conductrice du conducteur CB en aluminium ou en cuivre (matériaux très conducteurs) et la bande conductrice du matériau CA en silicium polycristallin ou nitrure de titane ou nitrure de tantale ou tungstène, ou un autre matériau beaucoup moins conducteur que l'aluminium ; on jouera aussi sur les épaisseurs des couches et on choisira des largeurs différentes pour les conducteurs CA et CB, le conducteur CA étant plus étroit que le conducteur CB. Par exemple, si le gain en courant des transistors est égal à 200, on peut donner aux conducteurs CA et CB des largeurs respectives de 1,5 et 30 micromètres, en réalisant le conducteur CB en aluminium et le conducteur CA en un matériau de résistance par carré 10 fois plus élevée que celle du conducteur CB (par exemple du silicium polycristallin ou du nitrure de titane d'épaisseur appropriée).

On comprend donc que contrairement à l'art antérieur, on n'essaye pas de minimiser la résistance linéique des deux conducteurs car cela aboutirait à des largeurs trop importantes lorsque N est très grand, mais on adapte judicieusement l'une des résistances linéiques en fonction de l'autre.

La figure 7 représente d'une manière physiquement réaliste une manière de réaliser le circuit intégré selon l'invention. On voit que la bande conductrice constituant le conducteur CA, qui part du circuit CT, est beaucoup plus étroite que celle du conducteur CB qui part du plot conducteur PLT. Le plot est placé du côté du circuit élémentaire de rang 1 ; le circuit de référence de tension CT est placé de l'autre côté de la succession, c'est-à-dire du côté du circuit élémentaire de rang N.

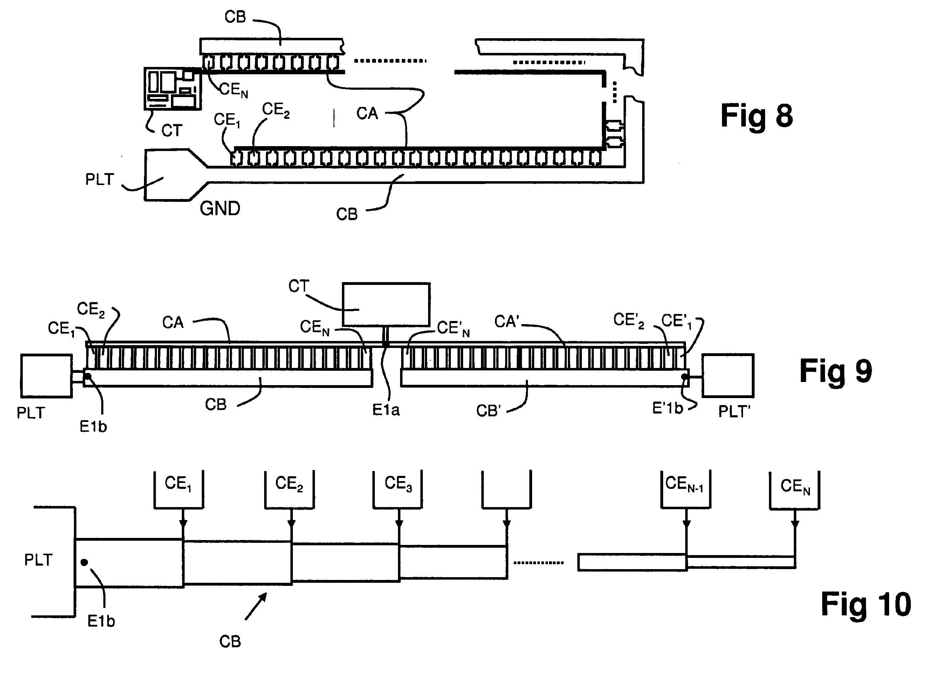

On notera que la succession de circuits élémentaires juxtaposés n'est pas forcément en ligne droite : elle peut être repliée sur deux ou trois ou quatre côtés, comme le montre la figure 8. Dans ces configurations repliées, l'entrée amont E1 b du conducteur CB est encore située du côté du circuit élémentaire $CE_1$ de rang 1 et est reliée directement au plot PLT, alors que l'entrée amont E1a du conducteur CA, située du côté du circuit élémentaire $CE_N$ de rang N, est connectée au circuit CT.

Si les circuits élémentaires sont particulièrement nombreux, on peut aussi envisager des configurations partiellement arborescentes, en dédoublant par exemple la succession des circuits élémentaires. La figure 9 représente à titre d'exemple une configuration à deux branches, particulièrement utilisable si on dispose de deux plots d'alimentation PLT et PLT' au même potentiel V0.

Il y a alors deux séries de circuits élémentaires symétriques $CE_1$, $CE_2$, jusqu'à $CE_N$ etc. pour la première succession, $CE'_1$, $CE'_2$, etc. jusqu'à $CE'_N$ pour la deuxième. Elles sont tournées en sens inverse l'une de l'autre, le rang j croissant de gauche à droite pour la première succession et de droite à gauche pour la deuxième. Les circuits de rang N des deux successions sont donc à proximité l'un de l'autre ; le circuit de référence CT est placé géographiquement à proximité de ces deux circuits élémentaires de rang N, et les conducteurs CA et CA' alimentent les successions dans l'ordre des rangs j décroissants, en commençant par les circuits de rang N.

A chaque plot conducteur PLT, PLT' sont reliés respectivement l'entrée amont E1 b d'un conducteur CB qui longe la première succession de circuits élémentaires et l'entrée amont d'un conducteur CB' qui longe la deuxième succession. Ces premières extrémités alimentent la succession dans l'ordre des rangs j croissants, en commençant par les circuits élémentaires de rang 1.

Pour améliorer encore la constance de la différence de potentiel au long de la succession de circuits élémentaires dans toutes ces configurations, on peut encore prévoir une largeur variable pour la bande conductrice la plus large (celle qui est parcourue par le courant le plus important, la bande constituant le conducteur CB dans les exemples donnés jusqu'ici). Les deux bandes conductrices CA et CB pourraient d'ailleurs avoir des largeurs variables, mais si on a adopté une largeur beaucoup plus étroite pour le conducteur CA en raison du rapport élevé ib/ia, c'est-à-dire en raison du gain en courant du transistor, on ne peut guère jouer en pratique sur la largeur de ce conducteur car on a intérêt en pratique à la minimiser.

Comme on le voit sur la figure 5, la variation de potentiel dans le conducteur CB ne suit pas une courbe parallèle à la variation de potentiel dans le conducteur CA. Le choix d'une largeur variable du conducteur CB permet de constituer une autre courbe de variation de potentiel le long du conducteur CB, la plus parallèle possible à la courbe de variation le long du conducteur CA. En effet, plus les courbes sont parallèles, plus la différence de potentiel est constante le long de la succession.

L'obtention de courbes parallèles repose sur le calcul suivant : on fait en sorte que le tronçon de conducteur CA de rang j produise la même chute de tension élémentaire que le tronçon de même rang du conducteur CB. Le tronçon de conducteur CA de rang j est parcouru par un courant (N-j)ia et le tronçon de conducteur CB de même rang est parcouru par un courant (j+1)ib. Connaissant le rapport entre les courants élémentaires ia et ib, on en déduit un rapport de résistances élémentaires à donner aux tronçons en vis-àvis.

Dans le cas où le conducteur CA a une largeur constante, le calcul montre qu'il faut donner au conducteur CB une largeur variable telle que le tronçon de rang j, qui relie les circuits élémentaires de rang j-1 et j, ait une largeur proportionnelle à (N-j+1)/j pour aboutir à des courbes de variation parallèles pour les deux conducteurs, donc à une minimisation de l'erreur de différence de potentiel au long de la succession.

La variation de largeur en (N-j+1)/j est une loi théoriquement optimale. Cependant, elle conduit à avoir des largeurs différentes pour chaque rang j. On pourra approximer cette loi en modifiant la largeur de la bande conductrice de manière discontinue avec un pas de changement de largeur plus long que le pas de répartition des circuits élémentaires. Par exemple on peut modifier la largeur avec un pas multiple du pas de répartition des circuits.

Par ailleurs, il faut comprendre que cette loi optimale donne une largeur de bande N fois plus grande au début de la succession (j=1) qu'à la fin de la succession (j=N). Or on peut être limité en largeur minimale comme en largeur maximale, pour des raisons de règles de dessin d'un côté et d'encombrement de l'autre. Par exemple, on peut considérer que la largeur minimale est de 1 micromètre et que la largeur maximale est de 30 micromètres. Dans ce cas, on pourra adopter différentes solutions d'approximation:

- on peut partir d'une largeur maximale de 30 micromètres au début (rang 1) de la succession, et on fera une approximation de la courbe idéale en conservant pour les derniers circuits élémentaires une largeur constante minimale de 1 micromètre au lieu de la réduire au-dessous d'un micromètre comme la courbe idéale le voudrait ;

- on peut aussi approximer la courbe en conservant une largeur maximale de 30 micromètres pour quelques premiers circuits élémentaires et en poursuivant la courbe de décroissance jusqu'au dernier rang j=N ;
- on peut encore approximer la courbe en ayant à la fois une largeur maximale constante de 30 micromètres pour quelques circuits élémentaires au début de la succession et une largeur minimale de 1 micromètre pour quelques circuits en fin de la succession ;
- on peut réaliser une variation selon la fonction indiquée ci-dessus d'une part en partant d'une largeur maximale au début de la succession et d'autre part en partant d'une largeur minimale en fin de la succession, en raccordant ces deux fonctions par exemple par une série de tronçons centraux de largeur constante ou de largeurs variables selon une fonction différente permettant d'effectuer progressivement ce raccordement.
- on peut enfin jouer aussi sur une variation de largeur du conducteur CA, bien que dans une faible mesure car il est en principe assez étroit.

Dans tout ce qui précède, on a considéré que chaque circuit élémentaire consommait un courant ia suffisant pour produire une chute de tension le long du conducteur CA, ce qui est le cas lorsque le courant est le courant de base d'un transistor bipolaire.

Mais dans certains circuits, le courant consommé par les circuits élémentaires est nul ou presque nul ; c'est le cas lorsque le conducteur CA applique un potentiel à la grille d'un transistor MOS. Il y a une chute de tension progressive dans le conducteur CB, mais il n'y a pas de chute de tension dans le conducteur CA qui compenserait en partie celle du conducteur CB.

Dans ce cas, on propose selon l'invention de connecter à l'extrémité aval du conducteur concerné (conducteur CA dans cet exemple) une source de courant de valeur im qui va provoquer une telle chute de tension progressive entre l'entrée amont du conducteur et l'extrémité aval. Le choix de la valeur du courant im est fait de préférence de manière à provoquer sur le conducteur CA, depuis le circuit élémentaire de rang N jusqu'au circuit élémentaire de rang 1, une chute de tension qui minimise les variations de différence de potentiel entre le conducteur CA et le conducteur CB le long de la succession de circuits élémentaires. On peut considérer que la variation est minimisée lorsque la valeur de la source de courant im est choisie égale à (Rb/Ra).ib.N/2

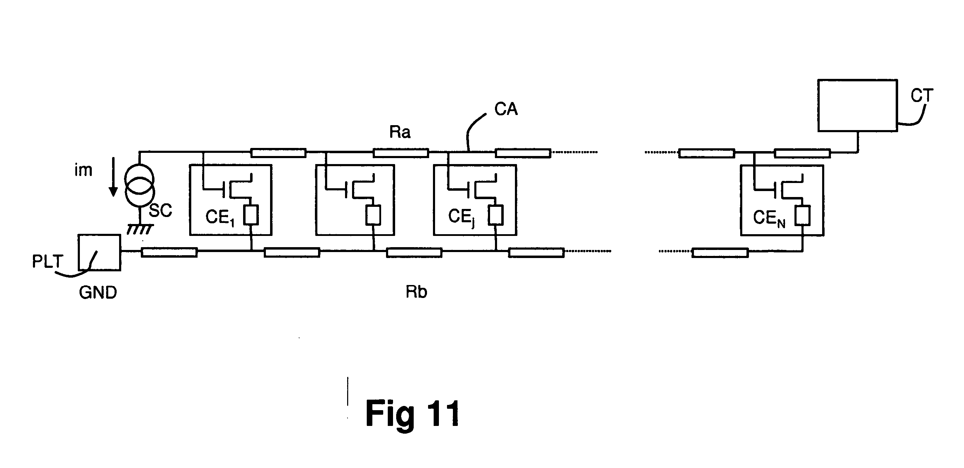

La figure 11 représente cette solution. Une source de courant SC de valeur im est placée à la deuxième extrémité du conducteur CA, la première étant celle qui est connectée au circuit de référence de tension CT.

On choisira une résistance beaucoup plus élevée pour le conducteur CA et la plus faible possible pour le conducteur CB et on en déduira la valeur im de la source de courant SC à utiliser. Par exemple, si le conducteur CA a une largeur trente fois plus faible que le conducteur CB et s'il est fait dans le même matériau que le conducteur CB, et si N est égal à 120, alors le courant im devra avoir une valeur égale à 2ib.

La chute de tension dans le conducteur CA n'a pas une forme parabolique comme c'était le cas à la figure 5 mais une forme linéaire puisque la totalité du courant im passe dans chacun des tronçons de conducteur CA. Cependant, la chute de tension dans le conducteur CB n'est pas linéaire mais parabolique. Il y a donc une erreur variable le long de la succession de circuits élémentaires.

Pour améliorer encore la constance de la différence de potentiel le long des deux conducteurs, on propose de compenser cette erreur en donnant au conducteur CB une configuration avec une largeur variable, se réduisant au fur et à mesure de la succession de circuits du rang 1 au rang N. La variation progressive de largeur est calculée pour linéariser la variation de potentiel dans le conducteur CB et pour lui donner la même pente que la variation linéaire sur le conducteur CA.

On y parvient en donnant au tronçon de rang j+1, prélevant le courant ib du circuit élémentaire de rang j+1 une résistance qui est dans le rapport (N-j)/(N-j+1) avec la résistance du tronçon précédent de rang j. Donc, on donnera de préférence au tronçon de rang j+1 une largeur dans le rapport inverse (N-j+1)/(N-j) avec la largeur du tronçon de rang j.

Là encore, les contraintes technologiques feront qu'on établira une variation suivant approximativement et non exactement cette loi, par exemple en changeant de largeur avec un pas de k tronçons (k>1) et non avec un pas de 1 tronçon. Egalement, si on choisit d'adopter une largeur minimum (par exemple au moins un micromètre de large) et/ou une largeur maximale (par exemple au plus 30 micromètres de large), on adaptera la loi de variation pour tenir compte de ces contraintes en restant proche de la loi en (N-j)/(N-j+1).

**Revendications**

1. Circuit intégré comportant une succession de N circuits élémentaires identiques ($CE_1$, $CE_2$, ...$CE_N$), juxtaposés dans l'ordre de leur rang j variant de 1 à N, N étant au moins égal à 20 et de préférence supérieur à 50, tous reliés à un premier conducteur (CA) qui est connecté, en un point (E1a) appelé entrée amont du premier conducteur, à un premier potentiel de référence (Vref), et qui s'étend à partir de cette entrée amont le long de la succession de circuits élémentaires, et tous reliés par ailleurs à un deuxième conducteur (CB) qui est connecté, en un point (E1b) appelé entrée amont du deuxième conducteur, à un deuxième potentiel de référence (V0), et qui s'étend à partir de cette entrée amont le long de la succession de circuits élémentaires, **caractérisé en ce que** l'entrée amont du deuxième conducteur est située géographiquement du coté du rang 1 de la succession de circuits juxtaposés, et l'entrée amont du premier conducteur est située géographiquement du côté du rang N de la succession de circuits juxtaposés.

**2.** Circuit intégré selon la revendication 1, **caractérisé en ce que** la résistance (Ra) d'un tronçon élémentaire de premier conducteur entre deux circuits élémentaires adjacents est dans un rapport béta avec la résistance Ra d'un tronçon élémentaire de deuxième conducteur entre deux circuits élémentaires adjacents, le rapport béta étant le rapport entre le courant (ib) tiré par le deuxième conducteur d'un circuit élémentaire et le courant (ia) tiré du premier conducteur par un circuit élémentaire lorsque les potentiels de référence sont appliqués aux conducteurs.

**3.** Circuit intégré selon la revendication 2, **caractérisé en ce que** le rapport de résistances est compris entre 20 et 500, de préférence entre 100 et 250.

**4.** Circuit intégré selon la revendication 1, **caractérisé en ce que** le premier conducteur a une largeur constante et le deuxième conducteur a une largeur variable décroissant progressivement depuis son entrée amont.

**5.** Circuit intégré selon la revendication 4, **caractérisé en ce que** la loi de décroissance de largeur suit au moins en partie une courbe d'allure générale en (N-j+1)/j en fonction du rang j du tronçon élémentaire de deuxième conducteur qui relie le circuit élémentaire de rang j-1 au circuit élémentaire de rang j.

**6.** Circuit intégré selon la revendication 1, dans lequel les circuits élémentaires consomment un courant nul à partir du premier conducteur, **caractérisé en ce que** ce conducteur s'étend le long de la succession de circuits élémentaires entre son entrée amont et une extrémité aval, une source de courant tirant un courant im de ce conducteur étant reliée à cette extrémité aval.

**7.** Circuit intégré selon la revendication 6, **caractérisé en ce que** le courant im de la source de courant a une valeur telle que

$$im = (Rb/Ra) \cdot ib \cdot (N/2),$$

où Ra est la résistance d'un tronçon élémentaire de premier conducteur entre deux circuits élémentaires adjacents, Rb est la résistance d'un tronçon élémentaire de deuxième conducteur entre deux circuits élémentaires adjacents, et ib est le courant tiré d'un circuit élémentaire par le deuxième conducteur lorsque les potentiels de référence sont appliqués aux conducteurs.

**8.** Circuit intégré selon la revendication 6, **caractérisé en ce que** le deuxième conducteur a une résistance par unité de longueur variable le long de la succession et une largeur décroissant progressivement depuis son entrée amont.

**9.** Circuit intégré selon la revendication 8, **caractérisé en ce que** la loi de décroissance de largeur suit au moins en partie une courbe d'allure générale en rapport (N-j)/(N-j+1) en fonction du rang j du tronçon élémentaire de deuxième conducteur qui relie le circuit élémentaire de rang j-1 au circuit élémentaire de rang j.

**10.** Circuit intégré selon l'une des revendications 1 à 9, **caractérisé en ce que** le premier conducteur est réalisé dans un matériau dont la résistance par carré est plus élevée que celle du matériau du deuxième conducteur.

**11.** Circuit intégré selon l'une des revendications 1 à 10, **caractérisé en ce que** le premier conducteur est moins large que la largeur moyenne du deuxième conducteur.

**Claims**

**1.** An integrated circuit comprising a succession of N identical elementary circuits ($CE_1$, $CE_2$, ...$CE_N$), juxtaposed in the order of their rank j varying from 1 to N, N being at least equal to 20 and preferably greater than 50, all connected to a first conductor (CA) which is connected, at a point (E1a) called upstream input of the first conductor, to a first reference potential (Vref) and which extends from this upstream input along the succession of elementary circuits, and all furthermore connected to a second conductor (CB) which is connected, at a point (E1 b) called upstream input of the second conductor, to a second reference potential (V0), and which extends from this upstream input along the succession of elementary circuits, **characterized in that** the upstream input of the second conductor is situated geographically on the side of the rank 1 of the succession of juxtaposed circuits, and the upstream input of the first conductor is situated geographically on the side of the rank N of the succession of juxtaposed circuits.

2.  The integrated circuit as claimed in claim 1, **characterized in that** the resistance (Ra) of an elementary section of first conductor between two adjacent elementary circuits is in a beta ratio with the resistance Ra of an elementary section of second conductor between two adjacent elementary circuits, the beta ratio being the ratio between the current (ib) drawn by the second conductor from an elementary circuit and the current (ia) drawn from the first conductor by an elementary circuit when the reference potentials are applied to the conductors.

3.  The integrated circuit as claimed in claim 2, **characterized in that** the ratio of resistances ranges between 20 and 500, preferably between 100 and 250.

4.  The integrated circuit as claimed in claim 1, **characterized in that** the first conductor has a constant width and the second conductor has a variable width decreasing progressively from its upstream input.

5.  The integrated circuit as claimed in claim 4, **characterized in that** the law of decrease in width follows at least partly a curve of (N-j+1)/j general form as a function of the rank j of the elementary section of second conductor which connects the elementary circuit of rank j-1 to the elementary circuit of rank j.

6.  The integrated circuit as claimed in claim 1, wherein the elementary circuits consume a zero current from the first conductor, **characterized in that** this conductor extends along the succession of elementary circuits between its upstream input and a downstream end, a current source drawing a current im from this conductor being connected to this downstream end.

7.  The integrated circuit as claimed in claim 6, **characterized in that** the current im of the current source has a value such that

$$im= (Rb/Ra) \cdot ib \cdot (N/2),$$

where Ra is the resistance of an elementary section of first conductor between two adjacent elementary circuits, Rb is the resistance of an elementary section of second conductor between two adjacent elementary circuits, and ib is the current drawn from an elementary circuit by the second conductor when the reference potentials are applied to the conductors.

8.  The integrated circuit as claimed in claim 6, **characterized in that** the second conductor has a resistance per unit of length that varies along the succession and a width decreasing progressively from its upstream input.

9.  The integrated circuit as claimed in claim 8, **characterized in that** the law of decrease in width follows at least partly a curve of general form as the ratio (N-j)/(N-j+1) as a function of the rank j of the elementary section of second conductor which connects the elementary circuit of rank j-1 to the elementary circuit of rank j.

10. The integrated circuit as claimed in one of claims 1 to 9, **characterized in that** the first conductor is made of a material of which the resistance per square is higher than that of the material of the second conductor.

11. The integrated circuit as claimed in one of claims 1 to 10, **characterized in that** the first conductor is narrower than the mean width of the second conductor.

EP 2 238 687 B1

**Patentansprüche**

1.  Integrierte Schaltung mit einer Folge von N identischen Elementarschaltungen ($CE_1$, $CE_2$, ...$CE_N$), die in der Reihenfolge ihres von 1 bis N variierenden Rangs j nebeneinander liegen, wobei N wenigstens gleich 20 und vorzugsweise größer als 50 ist, alle mit einem ersten Leiter (CA) verbunden, der an einem Punkt (E1a), Eingang stromaufwärts des ersten Leiters genannt, mit einem ersten Referenzpotential (Vref) verbunden ist und der von diesem stromaufwärtigen Eingang entlang der Folge von Elementarschaltungen verläuft, und alle darüber hinaus mit einem zweiten Leiter (CB) verbunden, der an einem Punkt (E1b), Eingang stromaufwärts des zweiten Leiters genannt, mit einem zweiten Referenzpotential (V0) verbunden ist und der von diesem stromaufwärtigen Eingang entlang der Folge von Elementarschaltungen verläuft, **dadurch gekennzeichnet, dass** sich der Eingang stromaufwärts des zweiten Leiters geografisch auf der Seite von Rang 1 der Folge von nebeneinander liegenden Schaltungen befindet und der Eingang stromaufwärts des ersten Leiters sich geografisch auf der Seite von Rang N der Folge von nebeneinander liegenden Schaltungen befindet.

2.  Integrierte Schaltung nach Anspruch 1, **dadurch gekennzeichnet, dass** der Widerstand (Ra) eines Elementarabschnitts des ersten Leiters zwischen zwei benachbarten Elementarschaltungen in einem Beta-Verhältnis mit dem Widerstand Ra eines Elementarabschnitts des zweiten Leiters zwischen zwei benachbarten Elementarschaltungen ist, wobei das Beta-Verhältnis das Verhältnis zwischen dem Strom (ib), der durch den zweiten Leiter einer Elementarschaltung gezogen wird, und dem Strom (ia) ist, der vom ersten Leiter durch eine Elementschaltung gezogen wird, wenn die Referenzpotentiale an die Leiter angelegt werden.

3.  Integrierte Schaltung nach Anspruch 2, **dadurch gekennzeichnet, dass** das Verhältnis der Widerstände zwischen 20 und 500, vorzugsweise zwischen 100 und 250 liegt.

4.  Integrierte Schaltung nach Anspruch 1, **dadurch gekennzeichnet, dass** der erste Leiter eine konstante Breite hat und der zweite Leiter eine variable Breite hat, die von seinem stromaufwärtigen Eingang aus progressiv abnimmt.

5.  Integrierte Schaltung nach Anspruch 4, **dadurch gekennzeichnet, dass** das Breitenabnahmegesetz wenigstens teilweise einer allgemeinen Verlaufskurve in (N-j+1)/j in Abhängigkeit vom Rang j des Elementarabschnitts des zweiten Leiters folgt, der die Elementarschaltung von Rang j-1 mit der Elementarschaltung von Rang j verbindet.

6.  Integrierte Schaltung nach Anspruch 1, bei der die Elementarschaltungen einen Nullstrom vom ersten Leiter verbrauchen, **dadurch gekennzeichnet, dass** der Leiter entlang der Folge von Elementarschaltungen zwischen seinem stromaufwärtigen Eingang und seinem stromabwärtigen Ende verläuft, wobei eine Stromquelle einen Strom im von diesem Leiter zieht, der mit diesem stromabwärtigen Ende verbunden ist.

7.  Integrierte Schaltung nach Anspruch 6, **dadurch gekennzeichnet, dass** der Strom im der Stromquelle einen solchen Wert hat, dass

$$im = (Rb/Ra) \cdot ib \cdot (N/2),$$

wobei Ra der Widerstand eines Elementarabschnitts des ersten Leiters zwischen zwei benachbarten Elementarschaltungen ist, Rb der Widerstand eines Elementarabschnitts des zweiten Leiters zwischen zwei benachbarten Elementarschaltungen ist, und ib der Strom ist, der von einer Elementarschaltung durch den zweiten Leiter gezogen wird, wenn die Referenzpotentiale an die Leiter angelegt werden.

8.  Integrierte Schaltung nach Anspruch 6, **dadurch gekennzeichnet, dass** der zweite Leiter einen Widerstand pro Längeneinheit hat, der entlang der Folge variabel ist, und eine von seinem stromaufwärtigen Eingang aus progressiv abnehmende Breite.

9.  Integrierte Schaltung nach Anspruch 8, **dadurch gekennzeichnet, dass** das Breitenabnahmegesetz wenigstens teilweise einer allgemeinen Verlaufskurve in dem Verhältnis (N-j)/(N-j+1) in Abhängigkeit vom Rang j des Elementarabschnitts des zweiten Leiters folgt, der die Elementarschaltung von Rang j-1 mit der Elementarschaltung von Rang j verbindet.

10. Integrierte Schaltung nach einem der Ansprüche 1 bis 9, **dadurch gekennzeichnet, dass** der erste Leiter aus einem Material gebildet ist, dessen Widerstand pro Quadrat größer ist als der des Materials des zweiten Leiters.

11. Integrierte Schaltung nach einem der Ansprüche 1 bis 10, **dadurch gekennzeichnet, dass** der erste Leiter weniger groß ist als die mittlere Breite des zweiten Leiters.

Fig 1

Fig 2

Fig 3

CT — Vref — Ra

E1a

ia    CE_N    V'0(N)    Rb

Ra

ia    CE_{N-1}    Rb

CA    Ra

Vref'(j)    Ra    ia    CE_{j+1}

CE_j    V'0(j)

CE_3

Vref'(1)    Ra    ia    CE_2

ia    CE_1    ib    C B    Rb

Rb

E1b

V0 = 0

PLT    GND

**Fig 4**

V'ref(j)    (fig 1)

V'0(j)    (fig 1)

**Fig 5**

V'ref(j)    (fig 3)

V'0(j)    (fig 3)

EP 2 238 687 B1

mV

910

900

890

880

0    5    10    15    20    25    30    35    40

j

**Fig 6**

CT

E1a

CE$_N$

CE$_{N-1}$

CA

CB

CE$_2$

CE$_1$

E1b

GND

PLT

**Fig 7**

**Fig 8**

**Fig 9**

**Fig 10**

Fig 11